# FASCICULE DE BREVET EUROPEEN

(11) **EP 3 020 256 B1**
(45) Date de publication et mention de la délivrance du brevet: **27.02.2019**
(21) Numéro de dépôt: 14731636.8
(22) Date de dépôt: 19.06.2014
(51) Int. Cl.: H05K 1/03, H05K 1/11, H05K 1/18, H05K 3/32, H05K 3/40, G06K 19/077, H01L 23/495, H01L 23/498, H01L 21/48, H01L 33/62

(54) **MODULE ÉLECTRONIQUE AVEC FILM DIELECTRIQUE ADHÉSIF ET SON PROCÉDÉ DE FABRICATION**
ELEKTRONISCHES MODUL MIT KLEBENDE DIELEKTRISCHE BESCHICHTUNG, UND SEIN HERSTELLUNGSVERFAHREN
ELECTRONIC MODULE WITH ADHESIVE DIELECTRIC FILM AND METHOD FOR MANUFACTURING SAME

(30) Priorité: 10.07.2013 EP 13305985; 23.08.2013 EP 13306169
(43) Date de publication de la demande: 18.05.2016
(73) Titulaire: Gemalto SA, 92190 Meudon (FR)
(72) Inventeur: OTTOBON, Stéphane, F-13705 La Ciotat (FR); DOSSETTO, Lucile, F-13705 La Ciotat (FR); DEGEILH, Line, F-13705 La Ciotat (FR)
(74) Mandataire: Milharo, Emilien
(86) Numéro de dépôt international: PCT/EP2014/062973
(87) Numéro de publication internationale: WO 2015/003884

(56) Documents cités:
- EP-A1- 0 307 773
- EP-A1- 0 438 742
- EP-A1- 2 178 032
- US-A- 4 833 022
- US-A1- 2001 030 122
- US-A1- 2004 159 462

## Description

L'invention se rapporte au domaine technique des modules électroniques, aux procédés de fabrication des modules électroniques, ainsi qu'aux dispositifs électroniques, en particulier aux cartes à puce, comprenant un tel module électronique.

De façon générale, les modules électroniques sont formés par assemblage d'un film diélectrique et d'une couche métallisée. La couche métallisée comprend des plages de contact d'un bornier de connexion, destinées à affleurer la surface d'un dispositif électronique tel qu'une carte à puce. Sur la face du film diélectrique, opposée à la couche métallisée, est fixée une puce électronique, dont les plots de contact sont connectés aux différentes plages de contact de la couche métallisée.

Classiquement, la puce est fixée sur le film diélectrique sa face active tournée vers l'extérieur du film, et ses plots de contact sont connectés aux plages de contact par l'intermédiaire de fils d'or qui passent à travers des réservations pratiquées dans l'épaisseur du film diélectrique, au regard des plages de contact. La puce est ensuite enrobée dans une résine de protection.

Les modules actuels à interface de communication duale sont onéreux car ils se comprennent un film métallique recto-verso, de larges surfaces de connexions pour assurer l'interconnexion avec une antenne placée dans un corps de carte à puce, une résine d'encapsulation, sept fils soudés de connexion électrique de la puce au module.

Les films à interface duale (contacts et sans contact) comportent un empilement de couches comme suit : cuivre métallisé / adhésif / diélectrique / adhésif pour coller la seconde face cuivre sur le diélectrique / cuivre métallisé. Dans certains cas, il peut ne pas y avoir d'adhésif sur les deux faces de cuivre. Notamment, dans le cas des technologies gravées, un des adhésifs peut être remplacé par un laminage à chaud du cuivre sur la matrice époxy du diélectrique. On obtient alors la superposition ci-après: cuivre métallisé / diélectrique / adhésifs pour coller la seconde couche de cuivre / cuivre métallisé.

Afin d'assurer la connexion des contacts ISO 7816 avec la puce et d'assurer la connexion des deux plages destinées à la liaison entre une antenne de la carte et la puce, le circuit flexible doit être double face (avec deux faces de cuivre). Ce qui le rend plus onéreux que les films simple face qui sont réalisés sur la base d'un cuivre, d'un adhésif et d'un diélectrique.

Par ailleurs, le fait d'avoir deux faces de cuivre avec motifs rend quasi impossible l'utilisation des technologies de grille découpée et laminée que l'on peut utiliser pour un simple face et qui sont elles aussi plus intéressantes économiquement. En effet, dans le cas d'un film double face, il faudrait faire une double lamination de deux grilles découpées et arriver à les indexer à + /- 100 µm ; ce qui est quasi impossible industriellement.

La réduction de taille des modules n'est pas possible pour des modules à interface duale. Les modules recto-verso pour interface duale sont environ trois fois plus onéreux par rapport aux petits modules de type à contacts électriques. Le même problème s'applique aux modules pour les cartes multi composants pouvant comporter notamment un afficheur et nécessitant des interconnexions à circuit imprimé.

Le document US 2004/0159462 décrit un procédé de fabrication d'un substrat flexible pour recevoir une puce électronique et former un composant électronique. Le flexible comprend une couche d'adhésif ayant sur une face une feuille métallique comprenant des plages d'interconnexion et sur une face opposée des vias électriques de connexion traversant la couche adhésive et débouchant sur cette face opposée. Les vias électriques de connexion relient des plots électriques d'une puce électronique aux plages d'interconnexion.

L'invention a donc pour but de remédier à au moins un des inconvénients de l'art antérieur. En particulier, l'invention vise à proposer un module électronique simple à fabriquer, peu coûteux.

Dans son principe, le film diélectrique (notamment époxy) onéreux est remplacé par un film adhésif, de préférence adhésif dans son intégralité ou dans la masse (100 % homogène) ou une couche / masse 100 % adhésive,); De préférence tous les endroits, ou lignes qui ont une absence de métal (cuivre) sur l'un des deux côtés des métallisations sont couverts au moins partiellement (couverts sur au moins 30 % de la surface des endroits ou lignes ci-dessus) ou sensiblement en majorité (par exemple couvert sur une surface supérieure à 50 % de la surface des endroits ou lignes ci-dessus) ou sensiblement en totalité, de métal par une deuxième couche et inversement.

Il en résulte que la raideur est maintenue ; Ainsi, aucune zone du module n'est affaiblie à l'endroit, zone ou ligne comportant dans le sens perpendiculaire au plan général du module seulement de l'adhésif.

A cet effet, l'invention a pour objet un module électronique selon la revendication 1 .

Selon d'autres caractéristiques ou variantes de réalisation, du module :
- Une puce électronique est électriquement connectée à ladite au moins une plage de contact, à travers des ouvertures de la couche isolante ;
- La seconde couche métallique est agencée par rapport à la première couche ou inversement, de manière à ce qu'elle chevauche à l'aplomb en totalité ou au moins dans sa grande majorité les lignes de séparation ou discontinuité des plages de contact ou des zones métalliques de la première couche ;
- La seconde couche métallique est formée d'une couche continue avec des perforations de connexion ou une couche ajourée régulièrement ;
- La seconde couche métallique forme au moins deux plages d'interconnexion destinées à connecter des plages de connexion d'une antenne et s'étendant sensiblement sur toute la surface inférieure du module ;

La seconde couche métallique forme au moins une antenne et/ou des plages de connexion à la puce.

L'invention a également pour objet un dispositif électronique comportant le module décrit ci-dessus tel qu'une carte à puce, une clé électronique....

L'invention a également pour objet un procédé de fabrication d'un module électronique selon la revendication 8 ;

Selon une caractéristique, le procédé comprend une étape d'agencement de la seconde couche métallique par rapport à la première couche ou inversement, de manière à ce qu'elle chevauche à l'aplomb en totalité ou au moins dans sa grande majorité les lignes de séparation ou discontinuité des plages de contact ou zones métalliques de la première couche.

### Description des figures :

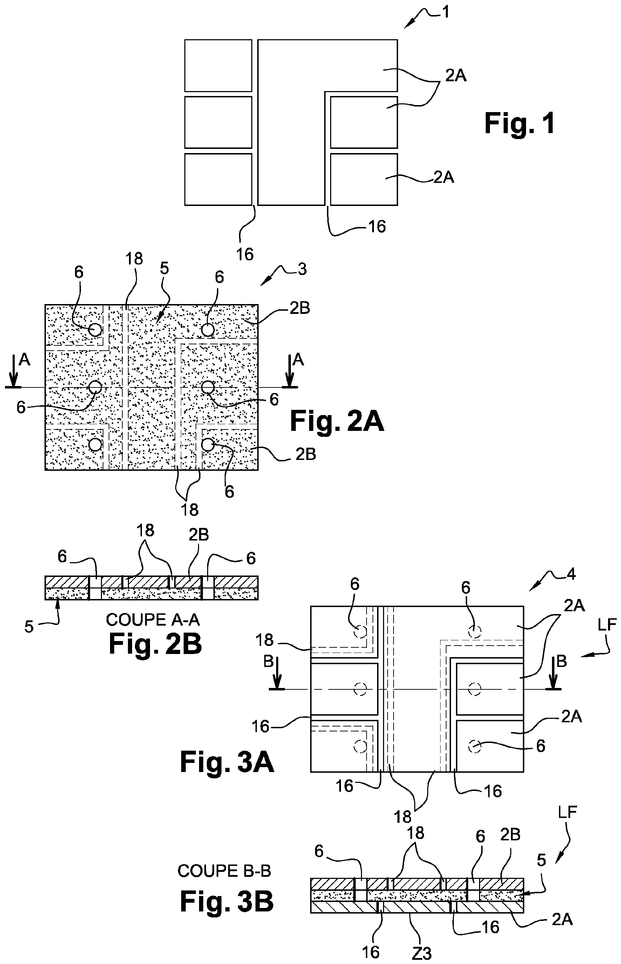

- Les figures 1 - 4, représentent des vue schématiques des étapes de mise en oeuvre du procédé de réalisation d'un module à puce électronique sans diélectrique selon un premier mode de réalisation de l'invention ; Ces figures illustrent à la figure 1, une première grille à contact en vue de dessus après découpe de son support de transport (ruban), puis à la figure 2A, une seconde grille en vue de dessus avec un adhésif pardessus sur la face interne destiné à être fixé sur à la première grille, puis à la figure 2B une coupe selon A-A de la figure 2A, puis une figure 3A représentant l'objet 3 de la figure 2A recouvert de la grille 1 de la figure 1 pour former un film de module laminé double face LF (double Lead -Frame), puis à la figure 3B une vue en coupe selon B-B de la figure 3A;
- La figure 4 illustre en coupe transversale le module complet M1 comportant le film double face des figures 3A, et 3B doté d'une puce 7 connectée avec un enrobage de protection 8 ;
- Les figures 5A, 5B représentent une vue schématique d'un second mode de réalisation d'un module à puce électronique M3 à contacts (simple interface) selon un troisième mode de réalisation de l'invention.
- La figure 6, représente une vue schématique d'un troisième mode de réalisation d'un module à puce électronique M2 à interface duale (contact et radiofréquence), sans diélectrique en vue de dessous et en coupe selon C-C réalisé selon un second mode de réalisation de l'invention ;
- La figure 7 illustre une plaque de cuivre pleine pour un emplacement de module ;
- La figure 8 illustre une autre plaque de cuivre pour un emplacement de module recouverte d'une couche ou d'un film d'adhésif;
- Les figures 9 et 10 illustrent respectivement une vue de dessus d'un module et une vue de dessous de la vue de face, les plaques de cuivre des figures 7 et 8 étant laminées ensemble l'une sur l'autre ;
- La figure 11 illustre un module ou laminé obtenu après gravure chimique des deux faces (ou au moins une face).

### Description de modes de réalisation :

Dans la suite de la description, on entend par « face avant », « face visible », « face externe » ou « couche externe » d'un module électronique, la face destinée à affleurer la surface d'un dispositif électronique. Au contraire, on entend par « face arrière » ou « face cachée » la face du module qui est destinée à être logée dans la cavité d'un dispositif électronique et à être cachée de l'extérieur.

Le terme « couche métallique » est utilisé pour désigner une couche comprenant des zones métalliques électriquement conductrices, délimitant par exemple des plages de contact et des pistes d'interconnexion. A contrario, le terme « film ou feuille métallique » désigne une couche entièrement métallique sans délimitation de zones spécifiques.

Les termes « cuivre », « grille de cuivre », « couche de cuivre » peuvent représenter respectivement et indifféremment « métal », « grille de métal », « couche de métal » autre que le cuivre. Dans certains cas, des surfaces ou couches conductrices notamment en carbone ou en polymère conducteur peuvent remplacer une feuille métallique conductrice électriquement sans sortir du cadre de l'invention.

Dans les différents modes de réalisation décrits, la plage de contact peut appartenir à un bornier de connexion à une ou plusieurs contact(s) pour connecter un lecteur externe à contact ou peut être substituée par une plage conductrice électriquement de connexion ou d'interconnexion ou une interface de communication radiofréquence.

La figure 1 représente un motif 1 de grille en cuivre après découpe mécanique.

Une grille de cuivre 1 peut être fournie de manière classique notamment par ruban continu de bobine ou de manière individualisée avec éventuellement des ponts de maintien des plages de contact 2A entre elles et/ou pistes d'amené de courant (ou pour mise à la masse) qui seront découpées par la suite. La face visible sur le dessin est la face avant destinée à contacter un connecteur de lecteur à contacts. La grille est présentée en vue de dessus.

La figure 2A représente un motif 3 de grille en cuivre après lamination avec un adhésif et après découpe mécanique. L'adhésif peut être « liquide » et étalé par un procédé adapté.

La grille de cuivre 3 peut est fournie comme précédemment en ruban continu ou en plaque et en vue de dessus (face destinée à être au contact du film adhésif) mais avec un motif de plage de contacts ou d'interconnexion 2B différent de la grille précédente. Cette grille 2B est laminée (de préférence avant découpe) avec un film adhésif notamment thermoactivable (réversible ou non) sur cette face. L'ensemble (grille + film adhésif) assemblé notamment par lamination à chaud ou à froid a été ensuite perforée par des trous 6 (traversant l'ensemble) ; Ces trous 6 vont servir à faire passer des connexions électriques 13 notamment filaire ou résine conductrice. Ces trous peuvent être dimensionnés ou associés à un pont isolant en résine de manière à éviter un court-circuit. Le cas échéant, les fils conducteurs peuvent comprendre un revêtement ou émail isolant.

Aux figure 3A (vue de dessus) et 3B (vue en coupe selon B-B), est représenté le film double face LF obtenu par lamination de la grille (1 ou 2A) de la figure 1 sur le laminé 3 des figures précédentes 2A, 2B. La grille 2A est fixée par collage sur l'ensemble 3 laminé de la figure précédente de manière à montrer un décalage des lignes de séparation 16 et 18 entre les deux grilles 2A et 2B. On constate avantageusement ici, dans une configuration optimale qu'aucune ligne de séparation 16 des plages de contact 2A ne coupe une ligne de séparation 18 des plages d'interconnexion de l'autre grille 2B (par projection perpendiculaire à la surface principale) et inversement. Ceci dit, dans une configuration moins optimisée, il n'est pas exclu d'avoir quelques points mineur de chevauchement (moins de 50 % de la surface de chaque ligne droite ou zone fragile) sans sortir du cadre de l'invention.

Une des couches métalliques ou feuilles peut être ajourée au moins au niveau des lignes ou zones fragiles exposées par l'autre couche métallique de manière à couvrir environ jusqu'à 50 - 40 % de la zone ou ligne fragile et ainsi constituer des surfaces de renfort.

Les surfaces de renfort métalliques sont situés à l'aplomb des lignes ou zones de fragilité et s'étendent en dessous des plages pour les chevaucher à l'aplomb ; Ces surfaces de renfort sont de préférence réparties régulièrement sous les lignes ou zones de fragilité. Par exemple, la couche peut être une grille quadrillée gravée ou découpée à partir d'une feuille métallique pleine. Par exemple aussi, un quadrillage ou un croisement perpendiculaire ou diagonal des lignes ou zones de fragilité peut être obtenu par une spirale d'une antenne active ou passive reliée ou non à la puce. L'homme du métier peut ajuster par essais mécaniques, le taux de renfort et répartition nécessaire en fonction de l'épaisseur de la feuille de métal, ses propriétés de tenue mécanique et de la durabilité escomptée.

Les deux couches métalliques des dessins peuvent éventuellement être permutées : par exemple, le renfort tel qu'une antenne peut être en surface externe du dispositif et des plages de contact ou d'interconnexion, voire plaques de condensateur en surface interne.

Cependant, l'invention trouve plus son intérêt dans un module à contact ou hybride (contact et radiofréquence) d'une carte à puce de circuit intégré du fait des tests mécaniques à respecter.

Les inventeurs avaient constatés que des cartes à puce avec modules à contacts électriques comportant simplement des plages de contact sur une matière thermo adhésive (sans film support diélectrique) pour adhère à un corps de carte pouvaient présenter rapidement des fissurations au niveau des lignes de séparation des plages de contact électrique (ou zones inter plages)

Le film à interface duale peut être réalisé via une technologie classique dont l'état de l'art fait référence par « lead frame contrecollé » (fourni par la société PRETEMA par exemple) mais qui dans l'invention présente l'avantage en ce que le diélectrique est supprimé et l'isolation électrique est assurée par un adhésif placé entre les 2 couches ou grille de cuivre ou autre métal conducteur.

Le diélectrique utilisé antérieurement peut être une résine époxy renforcée fibres de verre, un film en polyéthylène téréphtalate (PET), un film polyimide, un film polyéthylène naphtalate, (PEN), un film en polychlorure de vinyle (PVC). L'invention ne comprend pas ce type de diélectrique assemblé généralement par une couche d'adhésif à une grille ou couche métallique.

Cet adhésif peut avoir une épaisseur comprise de 15 à 50 µm. Les deux grilles nécessaires (d'une épaisseur de 50 à 100 µm) peuvent être découpées mécaniquement puis laminées entre elles de la même façon que s'il s'agissait d'une grille métallique et d'un diélectrique et ce sur des machines existantes.

Un des principes de l'invention réside notamment dans le fait d'assurer une rigidité suffisante à tous les endroits qui présentent une faiblesse de tenue mécanique, notamment une perforation ou absence de métal sur une des deux faces du cuivre. Ces endroits sont compensés par la présence de cuivre (ou autre métal) de la seconde couche ou vice et versa. Ainsi, le film fini (après lamination) ne présente pas en principe ou peu de trous débouchant, ni de zone ou ligne fragilisée ou seul l'adhésif est présent perpendiculairement à la surface principale du film laminé. Sont visées notamment des zones s'étendant de manière importante à la surface du module notamment des lignes de séparation de plages de contact s'étendant au moins sur environ 1/3 de la largeur des modules.

La couche de cuivre inférieure laminée avec l'adhésif est perforée afin de créer les trous borgnes de connexion avec les plots de la puce comme l'est aujourd'hui le diélectrique.

La réalisation du film double face selon un mode de réalisation de l'invention peut se faire de la même manière qu'un simple face à savoir une seule lamination : Cuivre / adhésif / Cuivre. Ce qui a pour conséquence de ramener le prix d'un film à interface duale à celui d'un film simple face (prix globalement divisé par deux) en supprimant le film diélectrique et une étape de lamination. Le cas échéant, les trous peuvent être préalablement réalisés séparément dans l'adhésif et la seconde couche métallique 2B.

L'adhésif peut être fixé ou fourni par tout moyen connu, par exemple projeté par jet de matière sur une des grilles avec formation des trous dans la même opération, sous forme solide liquide, polymérisable, thermo-activable, par sérigraphie....L'adhésif peut être un film ou une masse adhésive hétérogène continu ou discontinu mais de préférence homogène.

Par ailleurs, en supprimant une lamination, on simplifie considérablement la fabrication du film qui devient simple car cela limite le nombre d'opérations et ce d'autant plus que les deux grilles se trouvent peu découpées (afin de ne pas laisser de zones tenant qu'avec l'adhésif) ; Le film double face métallique est donc relativement robuste et facile à mettre en oeuvre.

Les techniques de métallisations sélectives qui sont devenues courantes dans le monde de la fabrication de circuit électronique flexible (par masquage ou outil mécanique) permettent de limiter le dépôt de métal précieux (Au, Pd, ...) à son strict minimum. L'absence de diélectrique et le fait que la grille de cuivre soit relativement pleine n'est donc pas préjudiciable en terme de coût.

Les deux grilles peuvent être métallisées de manière sélective juste aux endroits ou nous en avons besoin : sur les contacts ISO, les zones de soudure et éventuellement pour les zones de connexion à l' antenne.

Le fait d'assurer toujours la présence d'une des deux couches de cuivre au niveau des perforations garantit la rigidité de l'ensemble et évite les problèmes de fiabilité du produit fini. Par ailleurs, on peut également conserver le cuivre de la seconde face 2B sous la puce et assurer ainsi la bonne rigidité sous cette dernière également. La puce sera collée avec une colle non conductrice.

L'épaisseur totale du film double face ainsi réalisé est à peu près équivalente à celle actuelle (aujourd'hui 165 µm). Ce qui permet d'éviter de modifier les structures de corps de carte de manière drastique.

Les découpes des plages de contact sont de préférence positionnées et/ou agencées / dimensionnés de manière à éviter les courts circuits avec les fils de connexion qui pourrait venir toucher un bord de trou borgne (chaque zone des contacts ISO coté puce sont indépendantes.

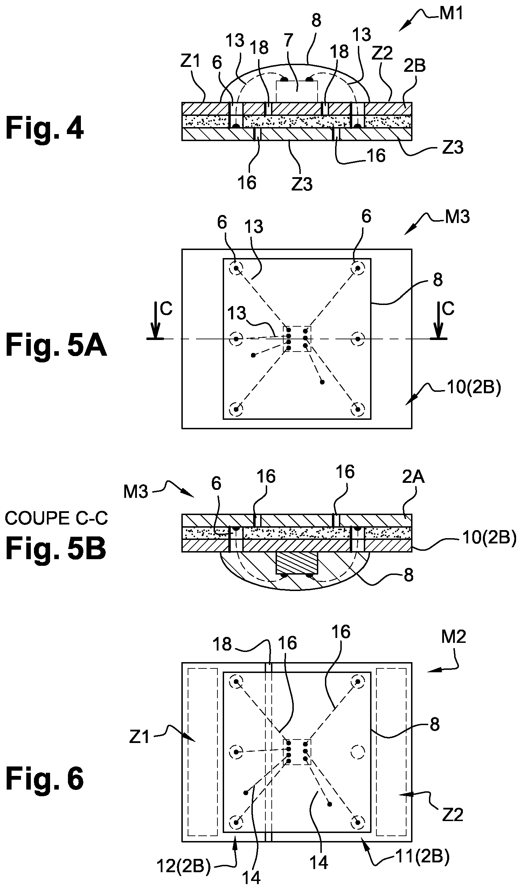

Dans le mode de réalisation, de la figure 3A, la seconde couche métallique 2B comporte des plages séparées les unes des autres pour notamment une meilleure isolation électrique comparativement au mode de réalisation de la figure 6 décrite ultérieurement.

Autre avantage, les plages sans contact de connexion antenne Z1, Z2 se retrouvent ainsi maximisées en surface; ce qui peut rendre plus aisées les techniques de connexion à l'antenne (mises en place par la suite) en terme de taille et de position des éléments conducteurs par exemple.

La figure 4 illustre en coupe transversale un module M1 connecté à une puce 4 par fils de connexion électrique ; La puce est reportée et connectée au film double face 4 de la figure 3A, 3B. Une résine de protection 8 recouvre la puce 7 et ses connexions 13. La puce est connectée à des plages d'interconnexion 2B comprenant des zones d'interconnexion Z1, Z2 destinées à connecter une antenne placée dans le corps d'une carte recevant le module M1.

De même, la grande surface de ces dernières plages d'interconnexion permet une grande flexibilité dans le choix des zones de soudure de fil or pour connecter la puce sur ces plages et ensuite pour interconnecter les zones Z1, Z2 à l'antenne.

Les figures 3A (en vue de dessus de la seconde grille) et 3B (coupe de la figure 3A) représentent l'assemblage par lamination des grilles de cuivre 2A et 2B ; Entre les deux se trouve l'adhésif 5 présent initialement sur la seconde grille en cuivre 2B). Il n'y a pas de zone fragile où serait présent l'adhésif uniquement dans le sens perpendiculaire au plan général du film double face.

Aux figures 3A, 3B, on observe que la seconde couche métallique 2B est agencée par rapport à la première couche 2A ou inversement, de manière à ce qu'elle chevauche à l'aplomb en totalité ou au moins dans sa grande majorité les lignes de séparation 16 ou discontinuité des plages de contact ou zones métalliques de la première couche 2A.

En particulier, une zone centrale métallique Z3 recouvre à l'aplomb les fentes 18 formées entre les plages latérales et plage centrale. Du film double métallisation de module. Ces fentes 18 constituent des zones de fragilisation du module qui seraient préjudiciables à la tenue mécanique des modules à l'occasion des tests normalisés de flexion / torsion notamment ISO 7816.

Selon ce mode de réalisation de l'invention, la seconde couche 2B comprend au moins des portions qui recouvrent totalement ou partiellement les fentes 16 ou des zones de la première couche 24 exemptes de métal conducteur. Dans une variante de la seconde couche métallique 2B, celle-ci peut être une plaque ajourée ou un grillage à ouvertures de préférence régulières dimensionnées de manière à assurer une résistance équivalente à une couche (ou film) métallique sensiblement continue.

A la figure 4, la puce est reportée et connectée. Les zones de connexion antenne Z1, Z2 sont larges (ici en pointillés) ; ce qui est un avantage et pour la soudure fil or et pour la connexion antenne : La puce est collée et les fils soudés 13 dans les puits 6 pour ceux reliant la face contact 2A et les fils 14 (visibles à la fig. 6) sont soudés sur les plots LA et LB de la puce et sur les plages sans contacts 2B (comportant les zones d'interconnexion Z1, Z2).

Aux figures 5A et sa vue en coupe transversale 5B, est illustrée une variante de l'invention qui se présente sous la forme ci-après ; On utilise le même cuivre 2A que précédemment à la figure 4, pour les plages de contact ; Par contre, pour le cuivre 2B (ou métallisation) caché dans le corps de carte, on utilise une plaque pleine continue dans laquelle se trouve juste des perforations 6 à travers la plaque permettant de souder les fils sur les plages de contact 2A. Alternativement, on peut utiliser une grille ajourée ou perforée régulièrement de manière à ne pas présenter de point prédéterminé de fragilité mécanique à l'un quelconque des endroits de la grille. Ainsi, le module M3 est un module à contacts uniquement dont le diélectrique a été remplacé par une couche métallique. Ce module comprend ici la puce 7 reportée, connectée et enrobée 8.

A la figure 6, dans une autre variante, les plages de connexion à l'antenne s'étendent cette fois ci de façon maximale puisque la grille 2B comporte uniquement deux plages d'interconnexion 12 (2B), 11(2B) définissant les deux zones d'interconnexion Z1, Z2 à l'antenne du corps de carte en dehors de l'enrobage 8. Ce module M2 est similaire à la construction de la figure 4 à la différence que la couche 2B comporte 2 plages d'interconnexion seulement. Ces plages 12, 11 offrent beaucoup de liberté pour la connexion des plots LA, LB de la puce aux plages d'interconnexion via les connexions 14.

De même, ces plages, offrent une grande surface de connexion à une antenne radiofréquence située dans un corps de carte destiné à recevoir le module hybride M2. On observe également que la ligne de séparation 18 de ces deux plages est disposée de manière à ne pas croiser ou du moins à ne pas se superposer une ligne de séparation 16 de la première couche 2A.

Grâce à l'invention, on peut réaliser un film simple face avec le même principe en remplaçant simplement le film diélectrique verre époxy par une plaque ou film de cuivre ou autre métal qui a au moins la fonctionnalité de rigidifier l'ensemble. En effet, le cuivre étant bien moins onéreux que le diélectrique verre-époxy, cela s'avère très économique.

Selon un autre mode de mise en oeuvre alternatif ou secondaire, l'invention peut mettre en oeuvre une technique de gravure de métal ou du « lead frame » (LF) à la place de la technique de découpe du métal dans les modes de réalisation précédents.

Un mode alternatif par gravure peut être le suivant dans le quel on fournit des plaques pour au moins un module ou une pluralité de module (les plaques peuvent aussi être fournies en ruban continu ou plaque de grandes dimensions comportant plusieurs emplacement de module qui seront découpées le cas échéant):

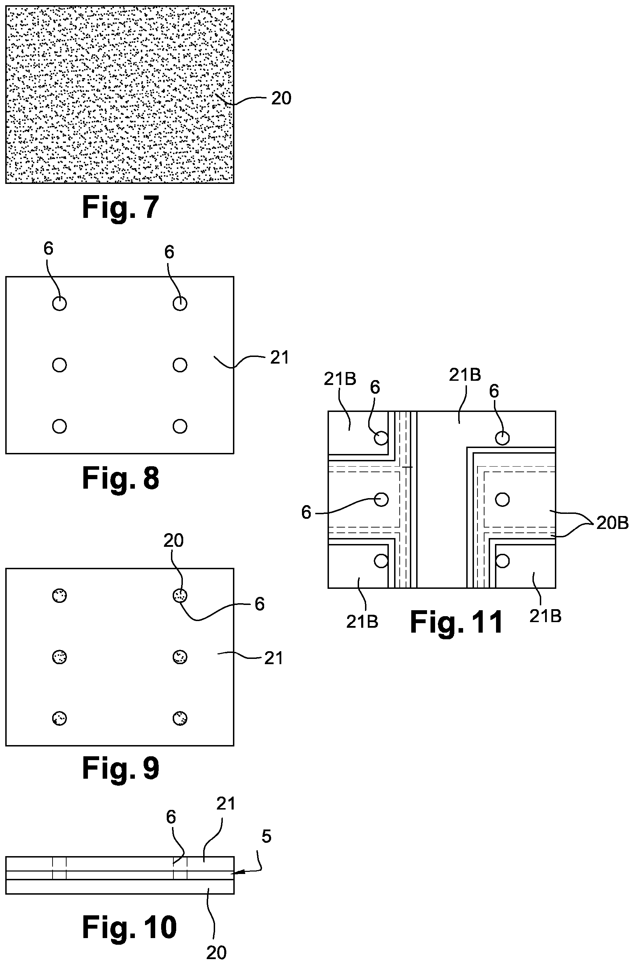

A la figure 7, une plaque métallique ou feuille de cuivre 20 pleine pour un emplacement de module est fournie. Elle peut être obtenue notamment à partir d'un laminoir.

A la figure 8, une autre plaque ou feuille de cuivre 21, pour un emplacement de module, est fournie avec un recouvrement d'une couche ou film d'adhésif sur une face d'assemblage (non visible sur la figure); Elle comporte des perforations 6, effectuées notamment par découpe mécanique et de préférence après assemblage de l'adhésif de manière à ôter l'adhésif au niveau des perforations et offrir un passage pour des fils de connexion notamment par soudure électrique ; Alternativement, on peut laminer un adhésif déjà perforé aux mêmes endroits. Alternativement aussi, l'adhésif peut être retiré des perforations par laser ou on peut éventuellement effectuer une connexion électrique à travers l'adhésif.

Aux figures 9 et 10, les plaques de cuivre 20 et cuivre 21 sont laminées ensemble l'une sur l'autre et fixées l'une à l'autre grâce à l'adhésif 5 situé entre les deux.

A la figure 11, une gravure chimique des deux faces (ou au moins une face) est réalisée par des technologies classiques de réalisation de film métallisé. La face visible sur la figure comporte des gravures des plages d'interconnexions 21B ou zone de soudure (ces plages sont destinées normalement à constituer la face cachée d'un module). La face opposée du module comporte une gravure des plages de contact électrique 20B notamment au format ISO 7816 pour connecter un lecteur à contacts.

On constate que l'invention permet d'obtenir dans ce mode de réalisation, un module (ou d'une manière générale un laminé, assemblage composite comportant des circuits électriques ou métalliques sans aucun trou qui perforerait totalement le module résultant.

De même, le module ne comporte pas de zone de fragilité où ne serait présent que l'adhésif. Il y a donc une présence d'au moins une couche de cuivre sur toute la surface de l'assemblage des plaques (ou du laminé). Ce module est donc plus résistant à des tests de flexion / torsion que s'il comprenait des croisements ou chevauchement de lignes de séparation des plages de contact ou d'interconnexion. Comme déjà expliqué, le module peut comprendre certains croisements où chevauchements mineurs qui ne compromettent pas la tenue mécanique susvisée.

## Revendications

1. Module électronique (M) comportant une première couche conductrice (1) comprenant au moins une surface conductrice (2A), une couche électriquement isolante (5) sous forme d'un adhésif fixée par une première face à la première couche conductrice, une seconde couche ou feuille métallique (3, 2B, 10, 11, 12) fixée à la couche isolante sur sa seconde face opposée, un emplacement de puce ou une puce électronique (7) électriquement connectée à ladite au moins une surface conductrice (2A), à travers la couche isolante, **caractérisé en ce que** ladite seconde couche ou feuille métallique (3, 2B, 10, 11, 12) comprend des ouvertures ou orifices de connexion (6) pour connecter la puce.

2. Module électronique selon l'une des revendications 1, caractérisé en ce la seconde couche ou feuille métallique (2B) forme au moins deux plages ou plaques (11, 12).

3. Module électronique selon la revendication 1 ou 2, caractérisé en ce la seconde couche ou feuille métallique (2B) est agencée par rapport à la première couche ou inversement, de manière à ce qu'elle chevauche à l'aplomb en totalité ou au moins 30 % des lignes de séparation (16) ou discontinuités de ladite première couche conductrice (1).

4. Module électronique selon l'une des revendications 1 ou 3, caractérisé en ce la seconde couche ou feuille métallique (10, 2B) est ajourée régulièrement ou forme une grille.

5. Module électronique selon l'une des revendications 1 à 3, caractérisé en ce la seconde couche ou feuille métallique (2B) forme au moins deux plages d'interconnexion (11, 12) destinées à connecter des plages de connexions d'une antenne et s'étendant sensiblement sur toute la surface inférieure du module.

6. Module électronique selon l'une des revendications 1 à 5, caractérisé en ce la seconde couche ou feuille métallique (10) forme au moins une antenne et des plages de connexion à la puce.

7. Dispositif électronique comportant le module selon l'une quelconque des revendications précédentes.

8. Procédé de fabrication d'un module électronique comportant les étapes suivantes de :
- réalisation d'une seconde couche ou feuille métallique comportant au moins une zone ou plage métallique (2B, 10, 11, 12),
- fixation d'une couche électriquement isolante (5), choisie parmi un adhésif, un adhésif thermoactivable ou un film adhésif, sur une première face de ladite couche ou film métallique (2B, 10, 11, 12) pour former un ensemble (3),
- perforation des deux couches précédentes d'orifices ou d'ouvertures de connexion (6) pour connecter un composant électronique tel une puce à circuit intégré,
- fixation d'une première couche conductrice (3) comprenant au moins une plage conductrice (2A) à l'ensemble, (3) via la couche isolante (5),
- caractérisé en que ce que ladite seconde couche ou feuille métallique (2B) comprend des ouvertures ou orifices de connexion (6) pour connecter la puce.

9. Procédé selon la revendication précédente, **caractérisé en ce que** au moins deux plages ou plaques (11, 12) sont formées dans la seconde couche ou feuille métallique (2B).

10. Procédé selon la revendication précédente, caractérisé en ce la seconde couche métallique (2B) est agencée par rapport à la première couche (1, 2A) ou inversement, de manière à ce qu'elle chevauche à l'aplomb au moins 30 % des lignes de séparation (16) ou discontinuités de ladite première couche conductrice (1).

11. Procédé selon l'une des revendications 8 à 10, **caractérisé en ce qu'**il comprend une étape de report et connexion électrique d'une puce électronique à ladite au moins une plage de contact (2A), à travers des ouvertures ou orifices (6) de la couche isolante (5) et de ladite seconde couche ou feuille métallique (2B).

## Patentansprüche

1. Elektronisches Modul (M), welches eine erste leitfähige Schicht (1) umfasst, die mindestens eine leitfähige Oberfläche (2A) enthält, eine elektrisch isolierende Schicht (5) in Form eines Klebers, der über eine erste Seite an der ersten leitfähigen Schicht befestigt ist, eine zweite Schicht oder Metallfolie (3, 2B, 10, 11, 12), die an der zweiten gegenüberliegenden Seite der isolierenden Schicht befestigt ist, einen Steckplatz für einen Chip oder ein elektronischer Chip (7), der über die isolierende Schicht an mindestens eine leitfähige Fläche (2A) elektrisch angeschlossen ist, **dadurch gekennzeichnet, dass** besagte zweite Schicht oder Metallfolie (3, 2B, 10, 11, 12) Anschlusslöcher oder -öffnungen (6) zum Anschließen des Chips umfasst.

2. Elektronisches Modul nach Anspruch 1, **dadurch gekennzeichnet, dass** die zweite Schicht oder Metallfolie (2B) mindestens zwei Bereiche oder Plättchen (11, 12) bildet.

3. Elektronisches Modul nach Anspruch 1 oder 2, **dadurch gekennzeichnet, dass** die zweite Schicht oder Metallfolie (2B) in Bezug auf die erste Schicht oder umgekehrt so angeordnet ist, dass sie die Trennlinien (16) oder Diskontinuitäten der besagten ersten Leitschicht (1) in der Senkrechten komplett oder zumindest zu 30 % überlagert.

4. Elektronisches Modul nach einem der Ansprüche 1 oder 3, **dadurch gekennzeichnet, dass** die zweite Schicht oder Metallfolie (10, 2B) gleichmäßig gelocht ist oder ein Gitter bildet.

5. Elektronisches Modul nach einem der Ansprüche 1 bis 3, **dadurch gekennzeichnet, dass** die zweite Schicht (2B) mindestens zwei Bereiche (11, 12) bildet, die dazu bestimmt sind, die Verbindungsbereiche einer Antenne anzuschließen und die sich im Wesentlichen über die gesamte untere Fläche des Moduls zu erstrecken.

6. Elektronisches Modul nach einem der Ansprüche 1 bis 5, **dadurch gekennzeichnet, dass** die zweite Schicht oder Metallfolie (10) mindestens eine Antenne und Anschlussflächen für den Chip bildet.

7. Elektronische Vorrichtung, welche das Modul nach einem der vorhergehenden Ansprüche umfasst.

8. Verfahren zur Herstellung eines elektronischen Moduls, welches die folgenden Schritte fast:
- die Herstellung einer zweiten Schicht oder Metallfolie, welche mindestens eine Zone oder einen Bereich aus Metall (2B, 10, 11, 12) umfasst;
- die Befestigung einer elektrisch isolierenden Schicht (5), die aus einem Kleber, einem thermoaktivierbaren Kleber oder einer Klebefolie ausgewählt wird, auf einer ersten Seite der besagten Schicht oder Metallfolie (2B, 10, 11, 12), um eine Einheit (3) zu bilden;
- Perforierung der beiden vorhergehenden Schichten mit Anschlusslöchern oder -öffnungen (6), um ein elektronisches Bauteil, wie zum Beispiel einen IC-Chip, anzuschließen;
- Befestigung einer ersten leitfähigen Schicht (3), welche mindestens eine leitfähige Fläche (2A) umfasst, über die isolierende Schicht (5) an der Einheit (3);
- **dadurch gekennzeichnet, dass** besagte zweite Schicht oder Metallfolie (2B) Anschlusslöcher oder -öffnungen (6) zum Anschließen des Chips umfasst.

9. Verfahren nach dem vorhergehenden Anspruch, **dadurch gekennzeichnet, dass** mindestens zwei Bereiche oder Plättchen (11, 12) in der zweiten Schicht oder Metallfolie (2B) gebildet werden.

10. Verfahren nach dem vorhergehenden Anspruch, **dadurch gekennzeichnet, dass** die zweite metallische Schicht (2B) in Bezug auf die erste Schicht (1, 2A) oder umgekehrt so angeordnet ist, dass sie in der Senkrechten mindestens 30 % der Trennlinien (16) oder Diskontinuitäten der besagten ersten Leitschicht (1) überlagert.

11. Verfahren nach einem der Ansprüche 8 bis 10, **dadurch gekennzeichnet, dass** es einen Schritt der Übertragung und des elektrischen Anschlusses eines elektronischen Chips auf mindestens eine Kontaktfläche (2A) über Löcher oder Öffnungen (6) der isolierenden Schicht (5) und besagter zweiter Schicht oder Magnetfolie (2B) umfasst.

## Claims

1. An electronic module (M) comprising a first conductive layer (1) including at least one conductive surface (2A), an electrically insulating layer (5) as an adhesive attached to the first conductive layer via a first face, a second metal layer or sheet (3, 2B, 10, 11, 12) attached to the insulating layer on the opposite face thereof, a chip location or an electronic chip (7) electrically connected to said at least one conductive layer (2A) through the insulating layer, **characterized in that** said second metal layer or sheet (3, 2B, 10, 11, 12) comprises connection openings or holes (6) for connecting the chip.

2. An electronic module according to claim 1, **characterized in that** the second metal layer or sheet (2B) forms at least two pads or plates (11, 12).

3. An electronic module according to claim 1 or 2, **characterized in that** the second metal layer or sheet (2B) is arranged relative to the first layer or vice versa, so that it overlaps and is directly above, in whole or at least 30% of, the separation lines (16) or discontinuities of said first conductive layer (1).

4. An electronic module according to one of claims 1 or 3, **characterized in that** the second metal layer or sheet (10, 2B) comprises regular perforations or forms a grid.

5. An electronic module according to one of claims 1 to 3, **characterized in that** the second metal layer or sheet (2B) forms at least two interconnection pads (11, 12) for connecting terminal pads of an antenna and substantially extending over the whole lower surface of the module.

6. An electronic module according to one of claims 1 to 5, **characterized in that** the second metal layer or sheet (10) forms at least one antenna and pads for the connection to the chip.

7. An electronic device comprising the module according to any one of the preceding claims.

8. A method for manufacturing an electronic module comprising the following steps of:
- producing a second metal layer or sheet comprising at least one metal area or pad (2B, 10, 11, 12),
- attaching an electrically insulating layer (5), selected from an adhesive, a heat-activatable adhesive or an adhesive film, on a first face of said metal layer or film (2B, 10, 11, 12) to form an assembly (3),
- providing the above two layers with connection holes or openings (6) for connecting an electronic component such as an integrated circuit chip,
- attaching a first conductive layer (3) comprising at least one conductive pad (2A) to the assembly (3) via the insulating layer (5),
- **characterized in that** said second metal layer or sheet (2B) comprises connection holes or openings (6) for connecting the chip.

9. A method according to the preceding claim, **characterized in that** at least two pads or plates (11, 12) are formed in the second metal layer or sheet (2B).

10. A method according to the preceding claim, **characterized in that** the second metal layer (2B) is arranged relative to the first layer (1, 2A) or vice versa, so that it overlaps and is directly above, at least 30% of, the separation lines (16) or discontinuities of said first conductive layer (1).

11. A method according to one of claims 8 to 10, **characterized in that** it comprises a step of transfer and electric connection of an electronic chip to said at least one contact pad (2A), through openings or holes (6) in the insulating layer (5) and in said second metal layer or sheet (2B) .
